# EUROPEAN PATENT SPECIFICATION

(11) **EP 1 785 507 B1**
(45) Date of publication and mention of the grant of the patent: **14.10.2009**
(21) Application number: 06017605.4
(22) Date of filing: 24.08.2006
(51) Int. Cl.: C23C 18/22, C23C 18/16

(54) **Method for etching non-conductive substrate surfaces**
Verfahren zum Ätzen von nichtleitenden Substratoberflächen
Procédé de gravur de la surface d'un substrat non-conducteur

(30) Priority: 28.10.2005 DE 102005051632
(43) Date of publication of application: 16.05.2007
(73) Proprietor: Enthone, Inc., West Haven, CT 06516 (US)
(72) Inventor: Schildmann, Mark Peter, 42697 Solingen (DE); Prinz, Ulrich, Dr., 42651 Solingen (DE); Königshofen, Andreas, Dr., 51371 Leverkusen (DE)
(74) Representative: Stenger, Watzke & Ring

(56) References cited:
- EP-A- 0 146 723
- EP-A- 0 146 724
- DE-A1- 2 022 109
- US-B1- 6 559 242
- DATABASE WPI Week 198230 Derwent Publications Ltd., London, GB; AN 1982-62374E XP002480912 & JP 57 098529 A (MITSUBISHI RAYON CO LTD) 18 June 1982 (1982-06-18)
- DATABASE WPI Week 198406 Derwent Publications Ltd., London, GB; AN 1984-034291 XP002480913 & JP 58 225130 A (KIZAI KK) 27 December 1983 (1983-12-27)
- DATABASE WPI Week 198652 Derwent Publications Ltd., London, GB; AN 1986-343283 XP002480914 & JP 61 257480 A (SEIKO EPSON CORP) 14 November 1986 (1986-11-14)

## Description

The present invention relates to a method for etching a non-conducting substrate surface for preparing and providing the surface with adhesive strength before a metallization as well as to a corresponding etching solution.

The coating of non-conductive substrate surfaces, such as for example plastic surfaces, with metal coatings is a practice that is variously used for forming the surface properties of substrates.

The metallization of the surface makes this one for example electrically conductive, which is widely used in the field of manufacturing integrated circuits, printed circuits or other electric or electronic components. Furthermore, surfaces are coated for decorative reasons with metal layers having corresponding optical or haptical characteristics.

Principally it is possible to deposit metal layers galvanically or autocatalytically on substrate surfaces. Before a galvanic deposition the plastic surface to be metallized has to be made electrically conductive by appropriate pre-treatments. Such a treatment that provides the surface with conductivity is unnecessary for the autocatalytic deposition of metal layers.

Independent from the galvanic or autocatalytic metallization of the surface, this one normally has to be roughened for improving the adhesiveness of the metal layer on the substrate surface. This can be realized by a mechanical treatment or by an appropriate chemical treatment, for example with swelling agents or etchants.

For this, different methods are known from the state of the art. Thus, the German patent specification DE 101 24 631 discloses the treatment of a plastic surface to be coated with an acid permanganate solution for a method for the direct electrolytic metallization of electrically non-conductive substrate surfaces.

The German patent DE 197 40 431 C1 discloses an etching method for a method for the metallization of an electrically non-conductive surface area, in which the surface to be coated is prepared by means of an acidic etchant containing hydrogen peroxide. Beside hydrogen peroxide, the here disclosed etchant can also comprise an acid such as phosphoric acid or also organic compounds such as propan-2-ol or p-phenolsulphonic acid.

The printed publication DE 195 10 855 discloses a pre-treatment of substrate surfaces to be coated with a chromic acid containing sulphuric acid etchant for a method of selective or partial electrolytic metallization of substrates on non-conductive materials. Alternatively, an alkaline permanganate solution is disclosed as etchant.

The international patent application WO 99/13696 discloses a pre-treatment of surfaces to be metallized by means of a pickling or etching solution on the base of hydrogen peroxide for a metallization method of a substrate comprising electrically non-conductive surface areas. The disclosed etching solutions can furthermore contain phosphoric acid, methane sulphonic acid or ethanoic acid, wherein the resulting hydrogen ionic concentration is indicated with maximum 0.5 mol/kg solution.

The German patent application DE 100 54 544 also discloses a pre-treating etching method of substrate surfaces by means of a chromate ions containing solution for a method of chemical metallization of surfaces, in particular surfaces of acrylnitril/butadiene/styrene copolymers (ABS copolymers) and of a mixture of these copolymers. The solutions are essentially composed of chromium trioxide and concentrated sulphuric acid.

In all etching methods it is important to disintegrate the substrate surface in order to form the required adhesive surface for the metal layer to be deposited.

Substrates to be coated can be for example plastics, such as polyester, polyether, polyimides, polyurethanes, polyamides, epoxy resins, polysulfones, polyethersulfones, polyetherimides etc.

However, in particular for substrates on the base of polyamide, the methods known from the state of the art for the preparing treatment of surfaces, such as the etching with chromic-sulfuric acid mixture, alkaline solutions or acids, cause problems since these pretreatment methods lead to irreversible deteriorations of the polyamide surface.

An approach for solving these problems is the surface etching method disclosed in the magazine metalloberfläche volume 59 (2005) no. 4 on pages 55 and following, which uses a clearly reduced chromium trioxide portion. Hitherto, about 400 g/l chromium trioxide have been used in the state of the art, but the here disclosed method only works with about 80 g/l chromium trioxide.

JP 57098529 discloses a method for the etching of polyamide surfaces with a solution comprising a chloride compound of an element of the second or third main group of the periodic system of elements. Especially tin chloride, alluminium chloride and calcium chloride are mentioned as capable compounds of an etchant for polyamide surfaces.

JP 58225130 discloses a method for etching polyamide surfaces, too. Here, halogenides of the group IVa, Va, VIa, Vlla, VIII, lb, IIb, IIIb or IVb are mentioned as compounds of etchants.

JP 61257480 discloses the use of an acidic iron (II) chloride solution as etchant for polyamide surfaces. US 6559242 B1 discloses the use of an aqueous solution of peroxide compounds in combination with a transission metall salt for the activation of surfaces of thermoplastic substrates.

DE 2 022 109 A1 discloses the pretreatment of plastic surfaces with a solution comprising an organic solvent and a metal salt. EP 0 146 724 and EP 0 146 723 disclose a method for the pretreatment of polyamide substrates prior to an electroless metallization, wherein the polyamide surface to be metallized is treated with a halogene compound of the first or second main group of the periodic system of elements in combination with a swelling agent or solvent in combination with a metal chloride.

But the use of chromium trioxide is difficult because of the environmental problems caused by chromates.

Taking this into account, it is the object of the present invention to provide a method for etching a non-conductive substrate surface, in particular a polyamide surface, for preparing and providing the surface with adhesive strength, which method is able to overcome the disadvantages known from the state of the art and generates a sufficient surface roughness without using any chromates. Furthermore, it is the object of the present invention to provide a corresponding etching solution.

This aim is **achieved** by a method for etching a plastic surface before a metallization, that is characterized in that the surface to be etched is brought into contact with an etching solution which contains a halogenide and/or nitrate of the group consisting of Na, Mg, Al, Si, Sc, Ti, V, Cr, Mn, Fe, Co, Ni, Cu, Ca and Zn and wherein the etching solution further comprises a soluble coordinative compound of the general formula M¹ (HF₂).

Advantageously, chloride is used as halogenide. FeCl₃, FeCl₂, TiCl₃, CuCl₂, CrCl₃, ZnCl₂, MgCl₂, CaCl₂, MnCl₂ and CuCl₂ as well as Cr(NO₃)₃ have proven to be especially suitable.

Furthermore, the etching solution can advantageously contain a soluble fluoride. Herein, coordinative fluoride compounds of the general formula M1(HF2) have proven to be especially suitable. Herein, M can be for example a NH4 group. But all other soluble fluorides are equally suitable.

In the method according to the invention an etching solution is used which contains the halogenide and/or nitrate of the group consisting of Na, Mg, Al, Si, Sc, Ti, V, Cr, Ca, Mn, Fe, Co, Ni, Cu and Zn in a concentration comprised between at least 0.1 mol/l and the solubility limit. In the method according to the invention an etching solution is preferably used which contains the metal salt in a concentration comprised between about 0.5 mol/l and about 10 mol/l, preferably between about 2 mol/l and about 4 mol/l.

The etching solution used in the method according to the invention can contain the soluble fluoride in a concentration comprised between about 0.05 mol/l and about 10 mol/l, preferably between about 0.25 mol/l and about 3.6 mol/l and more preferably between 0.3 mol/l and about 1.8 mol/l.

Furthermore, the etching solution used in the method according to the invention can contain an acid. Herein, both organic and inorganic acids having a pKₛ value of < 5 can be used.

The acid can be contained in the etching solution used in the method according to the invention in a concentration comprised between about 0.01 mol/l and about 10 mol/l, preferably between about 0.1 mol/l and about 5 mol/I and more preferably between about 0.5 mol/l and about 3.0 mol/l.

For improving the moistening of the substrate surface to be treated, the etching solution used in the method according to the invention can contain a wetting agent. Herein, wetting agents that are stable in the acidic medium have proven to be advantageous. The wetting agents can be contained in the etching solution used in the method according to the invention in a concentration comprised between about 0.0001 mol/l and about 1.0 mol/l, preferably between about 0.001 mol/I and about 0.5 mol/I and more preferably between about 0.01 mol/I and about 0.1 mol/l.

Small quantities of precious metals or precious metal compounds can be added to the etching solution used in the method according to the invention. It is for example possible to add 75 ppm Pd²⁺ to the etching solution for an improved absorption of palladium colloids.

According to the invention, the plastic surface to be etched is brought into contact with the etching solution for a period between about 0.1 minutes and about 20 minutes, preferably between about 1.0 minutes and about 10 minutes. Herein, the temperature can be in a range comprised between about 15°C and about 65°C, preferably between about 25°C and about 35°C.

The etching solution and the etching method according to the invention provide a method for the metallization of substrate surfaces which is characterized by the process steps:
etching the surface with a etchant that contains a halogenide and/or a nitrate
contacting the etched surface with an activator solution containing a precious metal colloid or with a ionogenic precious metal activator solution
contacting the activated surface with an accelerator solution and
metallization of the treated surface in an autocatalytic metallization bath or a direct metallization bath.

The metal layers that have thus been deposited on the substrates are connected to the surface in a firmly adhering manner. This is in particular due to the advantageous etching treatment according to the etching method according to the invention with the etching solution according to the invention.

The following realization examples exemplarily show an etching method according to the invention as well as an etching solution according to the invention without however limiting the invention to the exemplary embodiments.

### Example 1

### Etching solution

500 g/l FeCl₃
50 ml/l HCl concentrated
10 g/l NH₄HF₂
5 ml/l wetting agent

### Example 2

### Etching method

A polyamide injection moulded part made of polyamide (6) was contacted with the etching solution described in example 1 at 50°C for 4 minutes. The injection moulded part to be metallized was rinsed before a subsequent autocatalytic metallization.

### Example 3

### Complete metallization process

A polyamide injection moulded part as used in example 2 was treated as follows:
- 4 minutes FeCl₃ Etchant at 50°C
- rinsing
- treatment with an activator solution, such as for example Udique 879W of company Enthone, at 26°C for 2 minutes
- rinsing
- contacting the substrate with an accelerator solution, such as for example Enplate Accelerator 860 of company Enthone, at room temperature for 2 minutes
- rinsing
- nickel-plating of the treated plastic surface by for example contacting it with Udique Nl 891 at a pH value of 9.0 at 30°C for 10 minutes
- rinsing
- further formation of the layers

The etching method according to the invention is advantageously compatible with many existing lines for the metallization of ABS plastics. It leads to a more uniform roughening and germination of the plastic surface and thus to a faster metallization with less defects, for example in the autocatalytic nickel-plating. The obtained results can be very well reproduced and no familiarization with the metallization process on laboratory scale is required. Furthermore, there is no need to adapt the stabilizer content in the metallization following the etching step.

## Claims

1. A method for etching a non-conducting substrate surface before a metallization,
**characterized in that**
the surface to be etched is brought into contact with an etching solution which contains a halogenide and/or nitrate of the group consisting of Na, Mg, Al, Si, Sc, Ti, V, Cr, Mn, Fe, Co, Ni, Cu, Ca and Zn and wherein the etching solution further comprises a soluble coordinative compound of the general formula M¹ (HF₂).

2. A method according to claim 1, **characterized in that** the used etching solution contains a metal salt of the group consisting of FeCl₃, FeCl₂, TiCl₃, CaCl₂, CuCl₂, CrCl₃, ZnCl₂, MaCl₂, MnCl₂ or Cr(NO₃)₃ as halogenide and/or nitrate.

3. A method according to claim 2, **characterized in that** the used etching solution contains ferric chloride.

4. A method according to claim 1, **characterized in that** M is a NH₄ group.

5. A method according to one of the preceding claims, **characterized in that** the used etching solution contains the halogenide and/or nitrate of the group consisting of Na, Mg, Al, Si, Sc, Ti, V, Cr, Mn, Fe, Co, Ni, Ca, Cu and Zn in a concentration comprised between at least 0.1 mol/l and the solubility limit, preferably between 0.5 mol/l and 10 mol/l, more preferably between 2 mol/I and 4 mol/l.

6. A method according to one of the preceding claims, **characterized in that** the used etching solution contains the soluble fluoride in a concentration comprised between 0.05 mol/l and 10 mol/l, preferably between 0.15 mol/l and 3.6 mol/l, more preferably between 0.3 mol/l and 1.8 mol/l.

7. A method according to one of the preceding claims, **characterized in that** the used etching solution contains an acid.

8. A method according to claim 7, **characterized in that** the used etching solution contains an organic or inorganic acid having a pKₛ value of ≤ 5 as acid.

9. A method according to one of the claims 7 or 8, **characterized in that** the used etching solution contains the acid in a concentration comprised between 0.01 mol/l and 10 mol/l, preferably between 0.1 mol/l and 5 mol/l and more preferably between 0.5 mol/l and 3.0 mol/l.

10. A method according to one of the preceding claims, **characterized in that** the used etching solution contains a wetting agent.

11. A method according to claim 10, **characterized in that** the used etching solution contains a wetting agent that is hydrolysis stable with respect to acids.

12. A method according to one of the claims 10 or 11, **characterized in that** the used etching solution contains the wetting agent in a concentration comprised between 0.0001 mol/l and 1.0 mol/l, preferably between 0.001 mol/l and 0.5 mol/l and more preferably between 0.01 mol/l and 0.1 mol/l.

13. A method according to one of the preceding claims, **characterized in that** the substrate surface to be etched is brought into contact with the used etching solution for a period between 0.1 minutes and 20 minutes, preferably between 1.0 minutes and 10 minutes.

14. A method according to one of the preceding claims, **characterized in that** the substrate surface to be etched is brought into contact with the used etching solution at a temperature comprised between 15°C and 65°C, preferably between 25°C and 35°C.

15. A method according to one of the preceding claims, **characterized in that** the substrate is a plastic of the group consisting of polyester, polyether, polyimide, polyurethane, epoxy resin, polysulfone, polyethersulfone, polyetherimide or polyamide.

16. A method for the metallization of plastic surfaces **characterized by** the process steps:
- etching the surface with an etching solution that contains a halogenide and/or a nitrate of the group consisting of Na, Mg, Al, Si, Sc, Ti, V, Cr, Mn, Fe, Co, Ni, Cu, Ca and Zn and wherein the etching solution further comprises a soluble coordinative compound of the general formula M¹ (HF₂)
- contacting the etched surface with an activator solution containing a precious metal colloid or with a ionogenic precious metal activator solution
- contacting the activated surface with an accelerator solution
- metallization of the treated surface in an autocatalytic metallization bath or a direct metallization bath.

17. A method according to claim 16, **characterized in that** the plastic surface to be metallized is etched at a temperature comprised between 25°C and 35°C.

18. A method according to one of the claims 16 or 17, **characterized in that** the plastic surface is etched for a period between 1.0 minutes and 10 minutes.

19. A method according to one of the claims 16 through 18, **characterized in that** the plastic surface is a polyamide surface or an ABS surface.

20. An etching solution for the preparing treatment of plastic surfaces to be metallized, **characterized in that** the etching solution contains a halogenide and/or nitrate of the group consisting of Na, Mg, Al, Si, Sc, Ti, Ca, V, Cr, Mn, Fe, Co, Ni, Cu and Zn and a soluble coordinative compound of the general formula M¹ (HF₂).

21. An etching solution according to claim 20, **characterized in that** the etching solution contains the halogenide in a concentration comprised between at least 0.1 mol/l and the solubility limit, preferably between about 0.5 mol/l and about 10 mol/l, more preferably between about 2 mol/l and about 4 mol/l.

22. An etching solution according to one of the claims 20 through 21, **characterized in that** the etching solution contains the soluble fluoride in a concentration comprised between at least 0.05 mol/l and 10 mol/l, preferably between 0.15 mol/l and 3.6 mol/l, more preferably between 0.3 mol/l and 1.8 mol/l.

23. An etching solution according to one of the claims 20 through 22, **characterized in that** the etching solution contains a ferrous chloride as halogenide.

24. An etching solution according to claim 23, **characterized in that** the etching solution contains ferric chloride.

25. An etching solution according to one of the claims 20 through 24, wherein M is NH₄.

26. An etching solution according to one of the claims 20 through 25, **characterized in that** the etching solution contains an acid.

27. An etching solution according to claim 26, **characterized in that** the etching solution contains an organic or inorganic acid having a pKₛ value of ≤ 5.

28. An etching solution according to claim 26 or 27, **characterized in that** the etching solution contains the acid in a concentration comprised between 0.01 mol/l and 10 mol/l, preferably between 0.1 mol/l and 5.0 mol/l and more preferably between 0.5 mol/l and 3.0 mol/l.

29. An etching solution according to one of the claims 20 through 28, **characterized in that** the etching solution contains a wetting agent.

30. An etching solution according to claim 29, **characterized in that** the etching solution contains the wetting agent in a concentration comprised between 0.0001 mol/l and 1.0 mol/l, preferably between 0.001 mol/l and 0.5 mol/l and more preferably between 0.01 mol/l and 0.1 mol/l.

31. An etching solution according to one of the claims 29 or 30, **characterized in that** the etching solution contains a wetting agent that is resistant to acidic hydrolysis.

32. An etching solution according to one of the claims 20 through 31, **characterized in that** the etching solution contains precious metals or precious metal compounds.

## Patentansprüche

1. Verfahren zum Ätzen einer nichtleitenden Oberfläche vor einer Metallisierung,
**dadurch gekennzeichnet,**
**dass** die zu ätzende Oberfläche mit einer Ätzlösung in Kontakt gebracht wird, die ein Halogenid und/oder Nitrat der aus Na, Mg, Al, Si, Sc, Ti, V, Cr, Mn, Fe, Co, Ni, Cu, Ca und Zn bestehenden Gruppe enthält, und dass die Ätzlösung ferner eine lösliche koordinative Verbindung der allgemeinen Formel M¹ (HF₂) enthält.

2. Verfahren nach Anspruch 1, **dadurch gekennzeichnet, dass** die verwendete Ätzlösung ein Metallsalz der aus FeCl₃, FeCl₂, TiCl₃, CaCl₂, CuCl₂, CrCl₃, ZnCl₂, MgCl₂, MnCl₂ oder Cr(NO₃)₃ als Halogenid und/oder Nitrat enthält.

3. Verfahren nach Anspruch 2, **dadurch gekennzeichnet, dass** die verwendete Ätzlösung Eisenchlorid enthält.

4. Verfahren nach Anspruch 1, **dadurch gekennzeichnet, dass** M eine NH₄ Gruppe ist.

5. Verfahren nach einem der vorhergehenden Ansprüche, **dadurch gekennzeichnet, dass** die verwendete Ätzlösung das Halogenid und/oder Nitrat der aus Na, Mg, Al, Si, Sc, Ti, V, Cr, Mn, Fe, Co, Ni, Ca, Cu und Zn bestehenden Gruppe in einer Konzentration zwischen zumindest 0,1 Mol/l und der Löslichkeitsgrenze, bevorzugt zwischen 0,5 Mol/l und 10 Mol/l, noch mehr bevorzugt zwischen 2 Mol/l und 4 Mol/l enthält.

6. Verfahren nach einem der vorhergehenden Ansprüche, **dadurch gekennzeichnet, dass** die verwendete Ätzlösung das lösliche Fluorid in einer Konzentration zwischen 0,05 Mol/l und 10 Mol/l, bevorzugt zwischen 0,15 Mol/l und 3,6 Mol/l, noch mehr bevorzugt zwischen 0,3 Mol/l und 1,8 Mol/l enthält.

7. Verfahren nach einem der vorhergehenden Ansprüche, **dadurch gekennzeichnet, dass** die verwendete Ätzlösung eine Säure enthält.

8. Verfahren nach Anspruch 7, **dadurch gekennzeichnet, dass** die verwendete Ätzlösung eine organische oder anorganische Säure mit einem pK_{S}-Wert von = 5 als Säure enthält.

9. Verfahren nach einem der Ansprüche 7 oder 8, **dadurch gekennzeichnet, dass** die verwendete Ätzlösung die Säure in einer Konzentration zwischen 0,01 Mol/l und 10 Mol/l, bevorzugt zwischen 0,1 Mol/l und 5 Mol/l und noch mehr bevorzugt zwischen 0,5 Mol/l und 3,0 Mol/l enthält.

10. Verfahren nach einem der vorhergehenden Ansprüche, **dadurch gekennzeichnet, dass** die verwendete Ätzlösung ein Netzmittel enthält.

11. Verfahren nach Anspruch 10, **dadurch gekennzeichnet, dass** die verwendete Ätzlösung ein Netzmittel enthält, das gegenüber Säuren hydrolysestabil ist.

12. Verfahren nach einem der Ansprüche 10 oder 11, **dadurch gekennzeichnet, dass** die verwendete Ätzlösung ein Netzmittel in einer Konzentration zwischen 0,0001 Mol/l und 1,0 Mol/l, bevorzugt 0,001 Mol/l und 0,5 Mol/l und noch mehr bevorzugt zwischen 0,01 Mol/l und 0,1 Mol/l enthält.

13. Verfahren nach einem der vorhergehenden Ansprüche, **dadurch gekennzeichnet, dass** die zu ätzende Substratoberfläche für eine Dauer zwischen 0,1 Minute und 20 Minuten, bevorzugt zwischen 1,0 Minuten und 10 Minuten mit der verwendeten Ätzlösung in Kontakt gebracht wird.

14. Verfahren nach einem der vorhergehenden Ansprüche, **dadurch gekennzeichnet, dass** die zu ätzende Substratoberfläche bei einer Temperatur zwischen 15°C und 65°C, bevorzugt zwischen 25°C und 35°C mit der verwendeten Ätzlösung in Kontakt gebracht wird.

15. Verfahren nach einem der vorhergehenden Ansprüche, **dadurch gekennzeichnet, dass** das Substrat ein Kunststoff der aus Polyester, Polyether, Polyimid, Polyurethan, Expoxidharz, Polysulfon, Polyethersulfon, Polyetherimid oder Polyamid bestehenden Gruppe ist.

16. Verfahren zum Metallisieren von Kunststoffoberflächen, **gekennzeichnet durch** die folgenden Verfahrensschritte:
- Ätzen der Oberfläche mit einer Ätzlösung, die ein Halogenid und/oder Nitrat der aus Na, Mg, Al, Si, Sc, Ti, V, Cr, Mn, Fe, Co, Ni, Cu, Ca und Zn bestehenden Gruppe enthält, wobei die Ätzlösung ferner eine lösliche koordinative Verbindung der allgemeinen Formel M¹ (HF₂) enthält;
- Kontaktieren der geätzten Oberfläche mit einer Aktivatorlösung, die ein Edelmetallkolloid enthält, oder mit einer ionogenen Edelmetall-Aktivatorlösung;
- Kontaktieren der aktivierten Oberfläche mit einer Beschleunigerlösung;
- Metallisierung der behandelten Oberfläche in einem autokatalytischen Metallisierungsbad oder in einem direkten Metallisierungsbad.

17. Verfahren nach Anspruch 16, **dadurch gekennzeichnet, dass** die zu metallisierende Kunststoffoberfläche bei einer Temperatur zwischen 25°C und 35°C geätzt wird.

18. Verfahren nach einem der Ansprüche 16 oder 17, **dadurch gekennzeichnet, dass** die Kunststoffoberfläche für eine Dauer zwischen 1,0 Minuten und 10 Minuten geätzt wird.

19. Verfahren nach einem der Ansprüche 16 bis 18, **dadurch gekennzeichnet, dass** die Kunststoffoberfläche eine Polyamidoberfläche oder eine ABS-Oberfläche ist.

20. Ätzlösung für die Vorbehandlung einer zu metallisierenden Kunststoffoberfläche, **dadurch gekennzeichnet, dass** die Ätzlösung ein Halogenid und/oder Nitrat der aus Na, Mg, Al, Si, Sc, Ti, Ca, V, Cr, Mn, Fe, Co, Ni, Cu, und Zn bestehenden Gruppe und eine lösliche koordinative Verbindung der allgemeinen Formel M¹ (HF₂) enthält.

21. Ätzlösung nach Anspruch 20, **dadurch gekennzeichnet, dass** die Ätzlösung das Halogenid in einer Konzentration zwischen mindestens 0,1 Mol/l und der Löslichkeitsgrenze, bevorzugt zwischen ca. 0,5 Mol/l und ca. 10 Mol/l, noch mehr bevorzugt zwischen ca. 2 Mol/l und ca. 4 Mol/l enthält.

22. Ätzlösung nach einem der Ansprüche 20 bis 21, **dadurch gekennzeichnet, dass** die Ätzlösung das lösliche Fluorid in einer Konzentration zwischen mindestens 0.05 Mol/l und 10 Mol/l, bevorzugt zwischen 0,15 Mol/l und 3,6 Mol/l, noch mehr bevorzugt zwischen 0,3 Mol/l und 1,8 Mol/l enthält.

23. Ätzlösung nach einem der Ansprüche 20 bis 22, **dadurch gekennzeichnet, dass** die Ätzlösung ein Eisen-II-chlorid als Halogenid enthält.

24. Ätzlösung nach Anspruch 23, **dadurch gekennzeichnet, dass** die Ätzlösung Eisen-III-chlorid enthält.

25. Ätzlösung nach einem der Ansprüche 20 bis 24, wobei M gleich NH₄ ist.

26. Ätzlösung nach einem der Ansprüche 20 bis 25, **dadurch gekennzeichnet, dass** die Ätzlösung eine Säure enthält.

27. Ätzlösung nach Anspruch 26, **dadurch gekennzeichnet, dass** die Ätzlösung eine organische oder anorganische Säure mit einem pK_{S}-Wert von = 5 enthält.

28. Ätzlösung nach Anspruch 26 oder 27, **dadurch gekennzeichnet, dass** die Ätzlösung die Säure in einer Konzentration zwischen 0,01 Mol/l und 10 Mol/l, bevorzugt zwischen 0,1 Mol/l und 5,0 Mol/l und noch mehr bevorzugt zwischen 0,5 Mol/l und 3,0 Mol/l enthält.

29. Ätzlösung nach einem der Ansprüche 20 bis 28, **dadurch gekennzeichnet, dass** die Ätzlösung ein Netzmittel enthält.

30. Ätzlösung nach Anspruch 29, **dadurch gekennzeichnet, dass** die Ätzlösung das Netzmittel in einer Konzentration zwischen 0,0001 Mol/l und 1,0 Mol/l, bevorzugt zwischen 0,001 Mol/l und 0,5 Mol/l und noch mehr bevorzugt zwischen 0,01 Mol/l und 0,1 Mol/l enthält.

31. Ätzlösung nach einem der Ansprüche 29 oder 30, **dadurch gekennzeichnet, dass** die Ätzlösung ein Netzmittel enthält, das gegen saure Hydrolyse beständig ist.

32. Ätzlösung nach einem der Ansprüche 20 bis 31, **dadurch gekennzeichnet, dass** die Ätzlösung Edelmetalle oder Edelmetallverbindungen enthält.

## Revendications

1. Procédé de gravure d'une surface de substrat non conductrice avant une métallisation,
**caractérisé en ce que** la surface à graver est mise en contact avec une solution de gravure contenant un halogénure et/ou un nitrate compris parmi Na, Mg, Al, Si, Sc, Ti, V, Cr, Mn, Fe, Co, Ni, Cu, Ca et Zn et dans lequel la solution de gravure comprend en outre un composé coordinatif soluble ayant la formule générale M¹(HF₂).

2. Procédé selon la revendication 1, **caractérisé en ce que** la solution de gravure utilisée contient un sel métallique appartenant au groupe formé par FeCl₃, FeCl₂, TiCl₃, CaCl₂, CuCl₂, CrCl₃, ZnCl₂, MgCl₂, MnCl₂ ou Cr(NO₃)₃ comme halogénure et/ou nitrate.

3. Procédé selon la revendication 2, **caractérisé en ce que** la solution de gravure utilisée contient du chlorure ferrique.

4. Procédé selon la revendication 1, **caractérisé en ce que** M est un groupe NH₄.

5. Procédé selon l'une des revendications précédentes, **caractérisé en ce que** la solution de gravure utilisée contient l'halogénure et/ou le nitrate faisant partie du groupe comprenant Na, Mg, Al, Si, Sc, Ti, V, Cr, Mn, Fe, Co, Ni, Ca, Cu et Zn à une concentration comprise entre au moins 0,1 mol/l et la limite de solubilité, de préférence entre 0,5 mol/l et 10 mol/l, en particulier entre 2 mol/l et 4 mol/l.

6. Procédé selon l'une des revendications précédentes, **caractérisé en ce que** la solution de gravure utilisée contient le fluorure soluble à une concentration comprise entre 0,05 mol/l et 10 mol/l, de préférence entre 0,15 mol/l et 3,6 mol/l, en particulier entre 0,3 mol/l et 1,8 mol/l.

7. Procédé selon l'une des revendications précédentes, **caractérisé en ce que** la solution de gravure utilisée contient un acide.

8. Procédé selon la revendication 7, **caractérisé en ce que** la solution de gravure utilisée contient comme acide un acide organique ou inorganique ayant une valeur de pKₛ ≤ 5.

9. Procédé selon l'une des revendications 7 ou 8, **caractérisé en ce que** la solution de gravure utilisée contient un acide à une concentration comprise entre 0,01 mol/l et 10 mol/l, de préférence entre 0,1 mol/l et 5 mol/l et en particulier entre 0,5 mol/l et 3,0 mol/l.

10. Procédé selon l'une des revendications précédentes, **caractérisé en ce que** la solution de gravure utilisée contient un agent mouillant.

11. Procédé selon la revendication 10, **caractérisé en ce que** la solution de gravure utilisée contient un agent mouillant résistant à l'hydrolyse par les acides.

12. Procédé selon l'une des revendications 10 ou 11, **caractérisé en ce que** la solution de gravure utilisée contient l'agent mouillant à une concentration comprise entre 0,0001 mol/l et 1,0 mol/l, de préférence entre 0,001 mol/l et 0,5 mol/l et en particulier entre 0,01 mol/l et 0,1 mol/l.

13. Procédé selon l'une des revendications précédentes, **caractérisé en ce que** la surface du substrat à graver est mise en contact avec la solution de gravure utilisée pendant une période comprise entre 0,1 minute et 20 minutes, de préférence entre 1,0 minute et 10 minutes.

14. Procédé selon l'une des revendications précédentes, **caractérisé en ce que** la surface de substrat à graver est mise en contact avec la solution de gravure utilisée à une température comprise entre 15°C and 65°C, de préférence entre 25°C et 35°C.

15. Procédé selon l'une des revendications précédentes, **caractérisé en ce que** le substrat est un plastique faisant partie du groupe comprenant le polyester, le polyéther, le polyimide, le polyuréthane, la résine époxy, la polysulfone, la polyéthersulfone, le polyétherimide ou le polyamide.

16. Procédé pour la métallisation de surfaces en plastique, **caractérisé en ce qu'**il comprend les étapes de :
- gravure de la surface avec une solution de gravure contenant un halogénure et/ou un nitrate faisant partie du groupe comprenant Na, Mg, Al, Si, Sc, Ti, V, Cr, Mn, Fe, Co, Ni, Cu, Ca et Zn, laquelle solution de gravure comprend en outre un composé coordinatif soluble ayant la formule générale M¹(HF₂),
- mise en contact de la surface gravée avec une solution d'activation contenant un métal précieux colloïdal ou avec une solution d'activation ionogène de métal précieux,
- mise en contact de la surface activée avec une solution accélératrice,
- métallisation de la surface traitée dans un bain de métallisation autocatalytique ou un bain de métallisation directe.

17. Procédé selon la revendication 16, **caractérisé en ce que** la surface en plastique à métalliser est gravée à une température comprise entre 25°C et 35°C.

18. Procédé selon l'une des revendications 16 ou 17, **caractérisé en ce que** la surface en plastique à métalliser est gravée pendant une période comprise entre 1,0 minute et 10 minutes.

19. Procédé selon l'une des revendications 16 à 18, **caractérisé en ce que** la surface en plastique est une surface en polyamide ou une surface en ABS.

20. Solution de gravure pour le traitement préparatoire de surfaces en plastique à métalliser, **caractérisée en ce qu'**elle contient un halogénure et/ou un nitrate faisant partie du groupe comprenant Na, Mg, Al, Si, Sc, Ti, Ca, V, Cr, Mn, Fe, Co, Ni, Cu et Zn et un composé coordinatif soluble ayant la formule générale M¹(HF₂).

21. Solution de gravure selon la revendication 20, **caractérisée en ce qu'**elle contient l'halogénure à une concentration comprise entre au moins 0,1 mol/l et la limite de solubilité, de préférence entre 0,5 mol/l et 10 mol/l, en particulier entre 2 mol/l et 4 mol/l.

22. Solution de gravure selon l'une des revendications 20 à 21, **caractérisée en ce qu'**elle contient le fluorure soluble à une concentration comprise entre 0,05 mol/l et 10 mol/l, de préférence entre 0,15 mol/l et 3,6 mol/l, en particulier entre 0,3 mol/l et 1,8 mol/l.

23. Solution de gravure selon l'une des revendications 20 à 22, **caractérisée en ce qu'**elle contient un chlorure ferreux comme halogénure.

24. Solution de gravure selon la revendication 23, **caractérisée en ce qu'**elle contient du chlorure ferrique.

25. Solution de gravure selon l'une des revendications 20 à 24, dans laquelle M est NH₄.

26. Solution de gravure selon l'une des revendications 20 à 25, **caractérisée en ce qu'**elle contient un acide.

27. Solution de gravure selon la revendication 26, **caractérisée en ce qu'**elle contient un acide organique ou inorganique ayant une valeur de pKₛ ≤ 5.

28. Solution de gravure selon la revendication 26 ou 27, **caractérisée en ce qu'**elle contient l'acide à une concentration comprise entre 0,01 mol/l et 10 mol/l, de préférence entre 0,1 mol/l et 5 mol/l et en particulier entre 0,5 mol/l et 3,0 mol/l.

29. Solution de gravure selon l'une des revendications 20 à 28, **caractérisée en ce qu'**elle contient un agent mouillant.

30. Solution de gravure selon la revendication 29, **caractérisée en ce qu'**elle contient l'agent mouillant à une concentration comprise entre 0,0001 mol/l et 1,0 mol/l, de préférence entre 0,001 mol/l et 0,5 mol/l et en particulier entre 0,01 mol/l et 0,1 mol/l.

31. Solution de gravure selon l'une des revendications 29 ou 30, **caractérisée en ce qu'**elle contient un agent mouillant résistant à l'hydrolyse par les acides.

32. Solution de gravure selon l'une des revendications 20 à 31, **caractérisée en ce qu'**elle contient des métaux précieux ou des composés de métaux précieux.
